# EUROPEAN PATENT APPLICATION

(11) **EP 2 672 528 A1**
(43) Date of publication of application: **11.12.2013**
(21) Application number: 13020032.2
(22) Date of filing: 06.06.2013
(51) Int. Cl.: H01L 31/0687, G01R 31/26

(54) **Radiation resistant inverted metamorphic multijunction solar cell**

(30) Priority: 07.06.2012 US 201213491390
(71) Applicant: Emcore Solar Power, Inc., Albuquerque NM 87123 (US)
(72) Inventor: Patel, Pravin, Albuquerque, NM 87123 (US); Cho, Benjamin, Albuquerque, NM 87112 (US)
(74) Representative: Wagner, Karl H.

(57) **Abstract**

A multijunction solar cell including a first solar subcell having a first band gap and a first short-circuit current; a second solar subcell disposed over the first solar subcell and having a second band gap greater than the first band gap and a second short-circuit current greater than the first short-circuit current by an amount in the range of 2% to 6%; a third solar subcell disposed over the second solar subcell and having a third band gap greater than the second band gap and a third short-circuit current less than the first short-circuit current by an amount in the range of 2% to 6%; and a fourth solar subcell disposed over the third solar subcell having a fourth band gap greater than the third band gap, and a fourth short-circuit current less than the third short-circuit current by an amount in the range of 6% to 10%, so that at an "end of life" state of the multijunction solar cell in an AM0 space environment the short-circuit current of each of the subcells are substantially identical.

## Description

### BACKGROUND OF THE INVENTION

### 1. Field of the Invention.

The present invention relates to a metamorphic multijunction solar cell for a space radiation environment, sometimes referred to as an air mass zero (AMO) environment. Such solar cells are used power sources by many satellites.

### 2. The Background Art.

The desire for higher conversion efficiency has driven the development of multijunction solar cells, that is solar cells having two or more solar subcells with different band gaps and arranged in order of decreasing band gap so that high energy radiation is absorbed by the first solar subcell, and less energetic photons pass through the first solar subcell and are absorbed by a subsequent solar subcell. To provide an increased number of solar subcells in each solar cell, it is known to use different materials for different solar subcells, in which case the solar cell is referred to as a metamorphic multijunction solar cell. Each solar subcell has an associated short circuit current, and conventionally the solar cell is designed to match the short circuit currents for each solar subcell to achieve maximum conversion efficiency.

The fabrication of inverted metamorphic solar cell structures, such as described in M. W. Wanlass et al., Lattice Mismatched Approaches for High Performance, III-V Photovoltaic Energy Converters (Conference Proceedings of the 31st IEEE Photovoltaic Specialists Conference, Jan 3-7, 2005, IEEE Press, 2005), involves growing the solar subcells on a growth substrate in reverse order, i.e. from the highest band gap solar subcell to the lowest band gap solar subcell, and then removing the growth substrate.

US 2010/0122724 A1, the whole contents of which are hereby incorporated herein by reference, discusses a four junction inverted metamorphic multijunction solar cell.

A key requirement of solar cells intended for space applications is the ability to withstand exposure to electron and proton particle radiation. Previous electron radiation studies conducted on InGaAs solar subcells have demonstrated lower radiation resistance relative to InGaP and GaAs, see M. Yamaguchi, "Radiation Resistance of Compound Semiconductor Solar Cells", J. Appl. Phys. 78, 1995, pp 1476-1480. Accordingly, the performance of InGaAs solar subcells will deteriorate in an AMO environment faster than InGaP or GaAs solar subcells. Thus, incorporating an InGaAs subcell into a "radiation hard" multijunction solar cell presents a challenge.

### SUMMARY OF THE INVENTION

The present invention aims to improve the performance of a metamorphic multijunction solar cell having at least two InGaAs solar subcells in an AMO environment. In accordance with the present invention, a mismatch is introduced into the short circuit currents associated with the solar subcells of the solar cell at beginning of life to allow for greater deterioration of the conversion efficiency of the at least two InGaAs solar subcells during deployment of the solar cell in an AMO environment. Contrary to expectations given the increased InAs content, an InGaAs solar subcell having a lower band gap energy has been found to be more radiation resistant than an InGaAs solar subcell having a higher band gap energy. As a result, at the beginning of the life of the solar cell, the short circuit current associated with the lower band gap InGaAs solar subcell is made less than the short circuit current associated with the higher band gap energy InGaAs solar subcell. In embodiments of the invention, the short circuit current associated with the lower band gap InGaAs solar subcell is made less than the short circuit current associated with the higher band gap energy InGaAs solar subcell by an amount in the range of 2% to 6%.

An embodiment of the present invention provides a multijunction solar cell having a first solar subcell composed of InGaAs and having a first band gap and a first short-circuit current, a second solar subcell composed of InGaAs disposed over the first solar subcell and having a second band gap greater than the first band gap and a second short-circuit current greater than the first short-circuit current by an amount in the range of 2% to 6%, a third solar subcell composed of GaAs disposed over the second solar subcell and having a third band gap greater than the second band gap and a third short-circuit current less than the first short-circuit current by an amount in the range of 2% to 6%, and a fourth solar subcell composed of InGaP disposed over the third solar subcell having a fourth band gap greater than the third band gap, and a fourth short-circuit current less than the third short-circuit current by an amount in the range of 6% to 10%. The first to fourth short circuit currents are set so that at an end of life state of the multijunction solar cell in an AMO space environment the short-circuit current of each of the subcells are substantially identical. The end of life state may correspond to a period of use in an AMO space environment of at least 15 years, or to exposure to a fluence of 1x10¹⁵ 1MeV electrons per square centimeter.

### BRIEF DESCRIPTION OF THE DRAWINGS

FIG. 1 schematically shows the main regions of a multijunction solar cell according to an embodiment of the invention;

FIG. 2 is a graph showing for each of four solar subcells of the multijunction solar cell illustrated in Figure 1, the variation over time of the ratio of the short circuit current density for that solar subcell and the short circuit current for the solar subcell having the largest band gap;

FIG. 3 is a graph showing the variation in conversion efficiency during the lifetime of the multijunction solar cell illustrated in Figure 1 in comparison with a current-matched multijunction solar cell.

### DESCRIPTION OF THE PREFERRED EMBODIMENT

Details of the present invention will now be described, including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of actual embodiments nor the relative dimensions of the depicted elements, and are not drawn to scale.

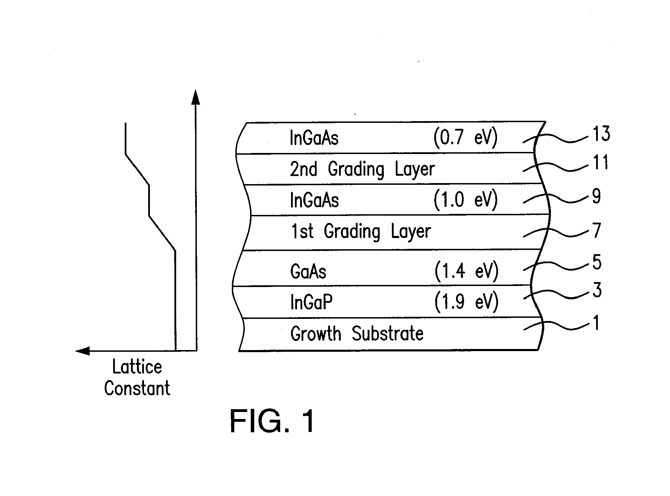

Figure 1 schematically shows an inverted metamorphic four junction solar cell, hereafter referred to as an IMM4J solar cell. In particular, Figure 1 shows an exploded view of the main layers of the IMM4J solar cell before removal of the growth substrate 1. It will be appreciated that the IMM4J solar cell shown in Figure 1 is typically reverse-mounted onto a surrogate substrate and the growth substrate 1 is removed prior to use.

An InGaP solar subcell 3 is deposited on the growth substrate 1, and a GaAs solar subcell 5 is deposited on the InGaP solar subcell 3 such that the InGaP solar subcell 3 is between the growth substrate 1 and the GaAs solar subcell 5. The InGaP solar subcell 3 and the GaAs solar subcell 5 are lattice-matched to the growth substrate 1.

A first graded interlayer 7 is interposed between the GaAs solar subcell 3 and a first InGaAs solar subcell 9 on the side of the GaAs solar subcell 5 opposing the InGaP solar subcell 1. The first graded interlayer 7 is a metamorphic layer for bridging the difference between the lattice constants of the GaAs solar subcell 5 and the first InGaAs solar subcell 9.

A second graded interlayer 11 is interposed between the first InGaAs solar subcell 9 and a second InGaAs solar subcell 13 on the side of the first InGaAs solar subcell 9 opposing the first graded interlayer 7. The second graded interlayer 11 is a metamorphic layer for bridging the difference between the lattice constants of the first InGaAs solar subcell 9 and the second InGaAs solar subcell 13.

The InGaP solar subcell 3 has a band gap of 1.9eV; the GaAs solar subcell 5 has a band gap of 1.4eV; the first InGaAs solar subcell 9 has a band gap of 1.0eV; and the second InGaAs solar subcell 13 has a band gap of 0.7eV. Accordingly, the plurality of solar subcells are arranged in order of decreasing band gap from the growth substrate. In this way, when solar radiation impinges from the growth substrate side (following removal of the growth substrate 1), photons having an energy in excess of 1.9eV are generally absorbed by the InGaP solar subcell 3, photons having an energy between 1.4eV and 1.9eV are generally absorbed by the GaAs solar subcell 5, photons having an energy between 1.0eV and 1.4eV are generally absorbed by the first InGaAs solar subcell 9 and photons having an energy between 0.7eV and 1.0eV are generally absorbed by the second InGaAs solar subcell 13. This results in a theoretical conversion efficiency of 40.8%.

A key requirement for solar cells intended for space applications is the ability to withstand exposure to electron and proton particle radiation. As mentioned previously, InGaAs solar cells are known to have lower radiation resistance than InGaP solar cells and GaAs solar cells. Accordingly, the short circuit current associated with InGaAs solar cells will fall at a faster rate than the short circuit current associated with InGaP solar cells and GaAs solar cells.

Conventionally, multijunction solar cells are designed such that at the beginning of the life of the solar cell, the short circuit currents for all the solar subcells are substantially identical. In this embodiment, to take account of the fact that the short circuit current for the first InGaAs solar subcell 9 and the second InGaAs solar subcell 13 will fall more quickly than that of the InGaP solar subcell 3 and the GaAs solar subcell 5, the short circuit currents for the solar subcells at the beginning of the life of the solar cell are mismatched such that the short circuit current at the end of life of the solar cell are substantially matched. In this way, the total energy conversion over the lifetime of the solar cell is improved.

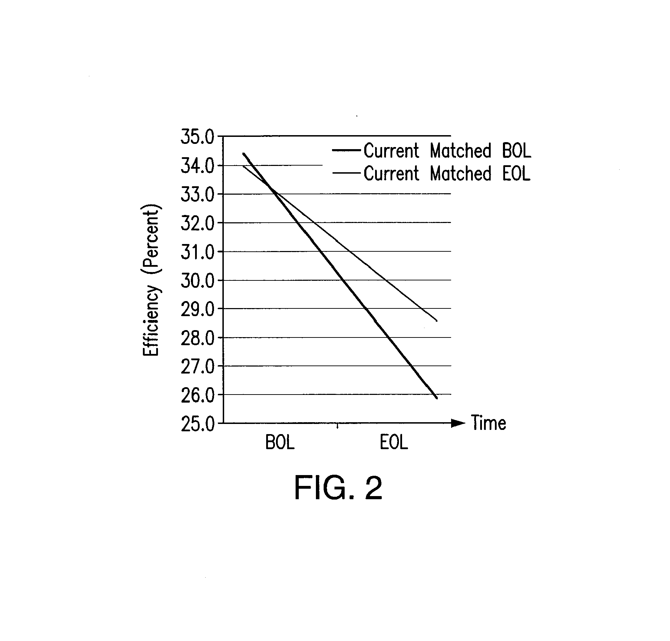

Figure 2 illustrates the conversion of the short circuit currents for the four solar subcells over the lifetime of the solar cell. In particular, the y-axis shows the value of the short-circuit current of each solar cell relative to the short circuit current of the InGaP solar cell 3. The variation of the short circuit currents of individual solar subcells over the lifetime was investigated using single junction cells which were fabricated to represent respective individual subcells, with surrounding subcell materials isotyped to produce the same device heat loads during growth as well as absorption characteristics for irradiation. The single junction cells were then exposed to 1-MeV electron radiation at fluences of 5E14 and 1E15 e/cm².

As expected, the first InGaAs solar subcell 9 and the second InGaAs solar subcell 11 exhibit lower radiation resistance that the InGaP solar subcell 3 and the GaAs solar subcell 5. Surprisingly, however, the second InGaAs solar subcell 11 exhibits higher radiation resistance than the first InGaAs solar subcell 9. This was not expected because the expectation was that the higher InAs content in the second InGaAs solar cell 11 would result in a higher degree of degradation in that subcell in comparison with the first InGaAs solar subcell 9.

One theory that may explain the higher radiation resistance of the second InGaAs solar subcell 11 in comparison with the first InGaAs solar subcell 9 is that the diffusion length at the beginning of life of the second InGaAs solar subcell 11 is much longer than that of the first InGaAs solar subcell 9, which would be due to the higher minority carrier concentration in InAs relative to GaAs. Accordingly, although the change in diffusion length once subjected to electron radiation of the second InGaAs solar subcell 11 may be larger than that of the first InGaAs solar subcell 9, the net diffusion length at end of life is still longer in the second InGaAs solar subcell.

The desired current mismatch between the solar subcells at beginning of life may be accomplished by varying the subcell thicknesses and the subcell band gap. In this embodiment, the additional current required by the GaAs solar subcell 5 is achieved by thinning the InGaP solar subcell 3 in comparison to the width required for current matching, while the additional current required by the first and second InGaAs solar subcells is generated by a slight reduction in band gap, resulting in an increase in the absorption band in comparison to the band gaps for current matching.

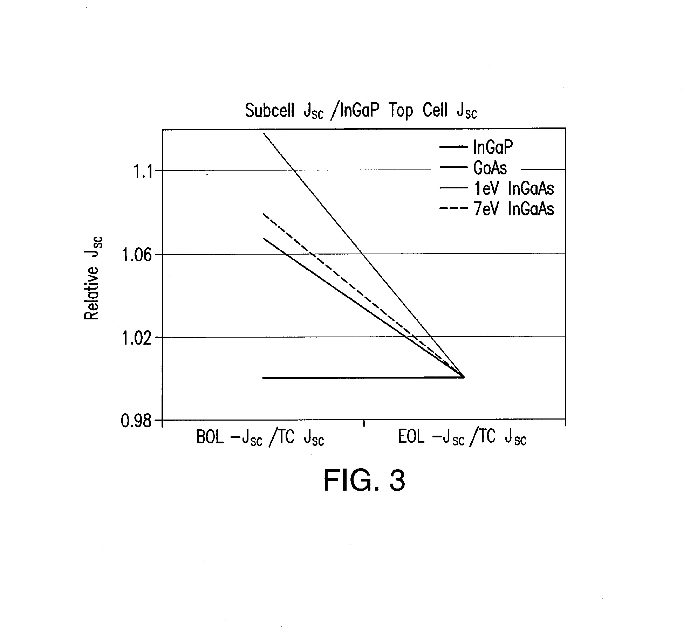

Following optimisation of the fabrication procedure, the IMM4J solar cell exhibited at beginning of life an AMO conversion efficiency of about 34%. This was a small decrease in comparison with an equivalent IMM4J solar cell that is current-matched at beginning of life but, as shown in Figure 3, the end of life remaining factor for the IMM4J solar cell according to the invention is significantly better than that of the equivalent IMM4J solar cell that is current-matched at beginning of life. The structure of the IMM4J solar cell according to the present invention provides an AMO conversion efficiency which varies over the life of the multijunction solar cell such that by the end of life of the multijunction solar cell the electrical energy generated is greater than for a multijunction solar cell having a structure which provides optimal beginning of life AMO conversion efficiency.

Although the solar cell described above is a four junction solar cell, it is envisaged that the present invention can also apply to other multijunction solar cells, for example five junction or six junction metamorphic solar cells (IMM5J or IMM6J solar cells).

## Claims

1. A multijunction solar cell comprising:
a first solar subcell composed of InGaAs and having a first band gap and a first short-circuit current;
a second solar subcell composed of InGaAs disposed over the first solar subcell and having a second band gap greater than the first band gap and a second short-circuit current greater than the first short-circuit current by an amount in the range of 2% to 6%;
a third solar subcell composed of GaAs disposed over the second solar subcell and having a third band gap greater than the second band gap and a third short-circuit current less than the first short-circuit current by an amount in the range of 2% to 6%; and
a fourth solar subcell composed of InGaP disposed over the third solar subcell having a fourth band gap greater than the third band gap, and a fourth short-circuit current less than the third short-circuit current by an amount in the range of 6% to 10%,
so that at an "end of life" state of the multijunction solar cell in an AMO space environment the short-circuit current of each of the subcells are substantially identical.

2. A multijunction solar cell according to claim 1, wherein the end of life state corresponds to a period of use in an AMO space environment of at least 15 years.

3. A multijunction solar cell according to claim 1, wherein the end of life state corresponds to exposure to a fluence of 1x10¹⁵ 1MeV electrons per square centimeter.

4. A multijunction solar cell according to claim 1, wherein the third solar subcell is lattice matched to the fourth solar subcell.

5. A multijunction solar cell according to claim 4, wherein a first graded interlayer is provided between the first and second solar subcells.

6. A multijunction solar cell according to claim 5, wherein a second graded interlayer is provided between the second and third solar subcells.

7. A multijunction solar cell for a space radiation environment, the multijunction solar cell having a plurality of solar sub-cells arranged in order of increasing band gap including:
a first solar subcell composed of InGaAs and having a first band gap, the first solar subcell having a first short circuit current associated therewith;
a second solar subcell composed of InGaAs and having a second band gap which is greater than the first band gap, the second solar subcell having a second short circuit current associated therewith;
wherein in a beginning of life state the second short circuit current is greater than the first short circuit current such that the AMO conversion efficiency is sub-optimal.

8. A multijunction solar cell according to claim 7, wherein the second short circuit current is greater than the first short circuit current by an amount in the range of 2% to 6%.

9. A multijunction solar cell according to claim 7, wherein said structure provides an AMO conversion efficiency which varies over the life of the multijunction solar cell such that by the end of life of the multijunction solar cell the electrical energy generated is greater than for a multijunction solar cell having a structure which provides optimal beginning of life AMO conversion efficiency.

10. A multijunction solar cell according to claim 9, wherein the end of life AMO conversion efficiency is greater than 82% of the beginning of life AMO efficiency.

11. A multijunction solar cell according to claim 10, wherein said end of life state corresponds to exposure to a fluence of 1x10¹⁵ 1MeV electrons per square centimeter.

12. A multijunction solar cell according to claim 8, wherein the plurality of solar sub-cells further includes:
a third solar subcell composed of GaAs and having a third band gap which is greater than the second band gap, the third solar subcell having a third short circuit current associated therewith that is less than the second short circuit current; and
a fourth solar subcell composed of InGaP and having a fourth band gap which is greater than the third band gap, the fourth solar subcell having a fourth short circuit current associated therewith which is less than the third short circuit current.

13. A multijunction solar cell according to claim 12, wherein the second short circuit current is greater than the first short circuit current by an amount in the range of 2% to 6%,
wherein the third short circuit current is less than the first short circuit current by an amount in the range of 2% to 6%, and
wherein the fourth short circuit current is less than the third short circuit current by an amount in the range of 6% to 10%.
